(19) Europäisches Patentamt
European Patent Office
Office européen des brevets

(11) Publication number : **0 633 499 A1**

(12) # EUROPEAN PATENT APPLICATION

(21) Application number : **94304991.6**

(51) Int. Cl.[6] : **G03F 7/004**

(22) Date of filing : **06.07.94**

(30) Priority : **07.07.93 JP 191838/93**

(43) Date of publication of application :
**11.01.95 Bulletin 95/02**

(84) Designated Contracting States :
**DE FR GB IT NL**

(71) Applicant : **JAPAN SYNTHETIC RUBBER CO., LTD.**
**11-24, Tsukiji-2-chome**
**Chuo-ku**
**Tokyo 104 (JP)**

(72) Inventor : **Inoue, Masaaki**
**7-10, Higashiisoyama-3-chome**
**Suzuka-shi (JP)**
Inventor : **Taira, Kazuo**
**1-14-203, Morigayamacho**
**Yokkaichi-shi (JP)**
Inventor : **Yumoto, Yoshiji**
**3698-1, Unemecho**
**Yokkaichi-shi (JP)**
Inventor : **Miura, Takao**
**22-6, Mitakidai-2-chome**
**Yokkaichi-shi (JP)**

(74) Representative : **Lamb, Martin John Carstairs**
**MARKS & CLERK,**
**57-60 Lincoln's Inn Fields**
**London WC2A 3LS (GB)**

(54) **Radiation sensitive resist composition.**

(57) A radiation-sensitive resist composition comprising a surface active agent having a perfluoroalkenyl group having 6 or more carbon atoms in the molecule. When said radiation-sensitive resist composition is filtered through a filter, the surface active agent is not adsorbed by the filter, so that striation is not caused and a coating film having a uniform thickness is always stably obtained from the above composition. Said radiation-sensitive resist composition is also excellent in developability.

EP 0 633 499 A1

## BACKGROUND OF THE INVENTION

This invention relates to a radiation sensitive resist composition useful for fine processing using various radiations.

In the field of fine processing using a lithographic technique for producing a semiconductor, a semiconductor integrated circuit and the like, resists are required to be excellent in radiation-responding characteristics such as resolution, sensitivity and the like and also capable of forming a coating film free from unevenness and having a uniform thickness in order to form a highly precise and fine resist pattern in which the mask pattern has been reproduced with high fidelity.

Representatives of the resists which have heretofore been used in fine processing include (i) a resist in which an alkali-soluble resin such as novolak resin or the like is compounded with a compound having a quinonediazide group as a sensitizing agent, (ii) a chemically amplified resist in which a radiation-sensitive acid generator which generates an acid upon irradiation with a radiation (the irradiation is referred to hereinafter as the exposure) is used and the sensitivity of the resist has been enhanced with the catalytic action of the acid generated, and the like.

However, the conventional resists have such common problems that uneven coating called "striation" is caused.

The striation is unevenness caused in a coating film when a resist is applied onto a substrate by, for example, a spin-coating, and shows a radial striped pattern in the visual observation, which pattern has wave-like undulations whose difference of altitude is usually about several hundreds of angstrom.

When such a striation is caused, such a problem is caused that the straight line shape and reproducibility of pattern are impaired and it becomes very difficult to form a resist pattern having the desired precision.

Under such circumstances, research has been made for inhibiting or preventing such a striation from being caused, and as a result, it has recently been found that the striation can be considerably prevented from being caused by incorporating a surface active agent such as a fluorine-containing surfactant or the like into the resist (see, for example, Japanese Patent Application Kokai No. 59-155,836). Also, it has been known that a photosensitive lithographic plate having a uniform film thickness can be formed from a photosensitive composition comprising a fluorine-containing surfactant (see Japanese Patent Application Kokai No. 54-135,004).

However, a resist is usually subjected to filtration through a filter in its preparation and its application to a substrate, and hence, if the resist contains a surface active agent as mentioned above, there is such a disadvantage that the surface active agent is adsorbed by the filter in the filtration and hence striation tends to be caused particularly just after the filter-exchange. If the amount of the surface active agent is increased to overcome the problem, such a further problem is caused that the developability is lowered in the formation of a resist pattern.

## SUMMARY OF THE INVENTION

It is an object of this invention to solve the above-mentioned problems of the prior art resists and provide a novel radiation-sensitive resist composition which does not cause striation because the surface active agent contained in the composition is not absorbed by a filter in the filtration, particularly just after filter-exchange, can form always stably a coating film having a uniform thickness and is also excellent in developability.

Other objects and advantages of this invention will become apparent from the following description.

According to this invention, there is provided a radiation-sensitive resist composition comprising a surface active agent having a perfluoroalkenyl group having 6 or more carbon atoms in the molecule, which can solve the above-mentioned problems.

## DETAILED DESCRIPTION OF THE INVENTION

### Surface active agent

The characteristic feature of the radiation-sensitive resist composition of this invention lies in adopting a surface active agent having a perfluoroalkenyl group having 6 or more carbon atoms in the molecule (referred to hereinafter as "Surfactant A") as a fluorine-containing surfactant to be incorporated into the composition, and hence, the Surfactant A is first explained.

The number of carbon atoms of the perfluoroalkenyl group which the Surfactant A has is 6 or more, preferably 6, 9 or 12. The perfluoroalkenyl group is preferably a group derived from at least two molecules, more preferably 2 to 4 molecules, of hexafluoropropane. When the perfluoroalkenyl group in the Surfactant A is a group derived from at least five molecules of hexafluoropropane, the solubility of the Surfactant A in a solvent

tends to be reduced. Also, when the perfluoroalkenyl group in the Surfactant A is a group derived from a single molecule of hexafluoropropane, the effect of this invention on the inhibition of striation becomes insufficient. Said Surfactant A may be nonionic, cationic, anionic or amphoteric.

The Surfactant A is preferably a compound represented by formula (1):

$$Rf - A - B \quad (1)$$

wherein Rf, A and B are as defined below.

In formula (1), Rf represents a perfluoroalkenyl group having 6 or more carbon atoms, and specific examples thereof include groups represented by the following formulas:

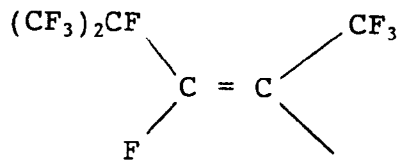

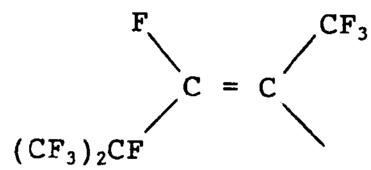

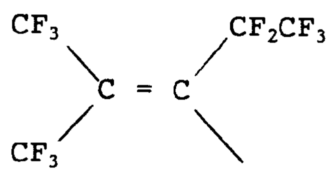

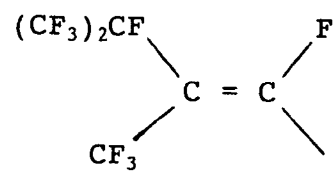

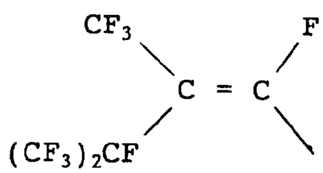

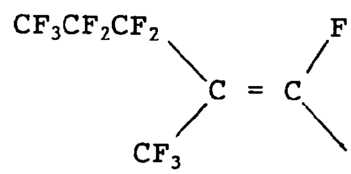

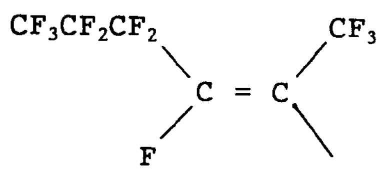

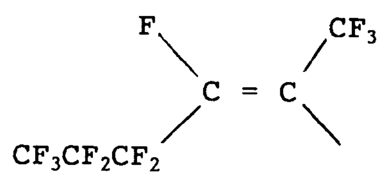

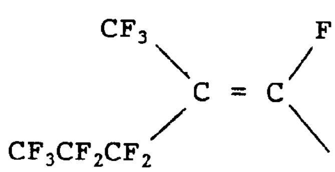

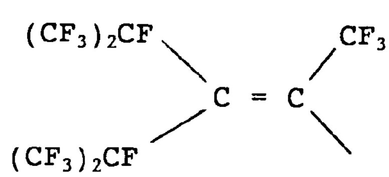

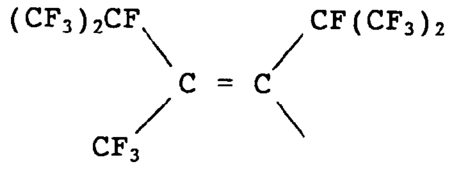

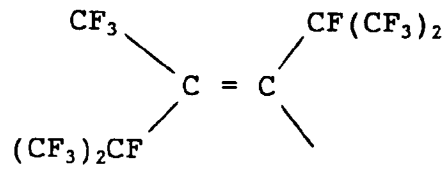

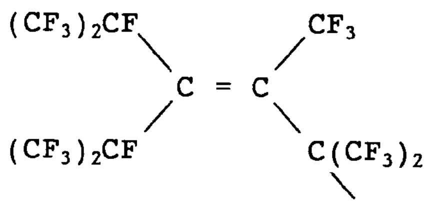

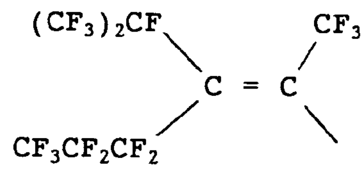

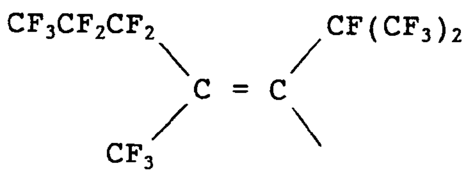

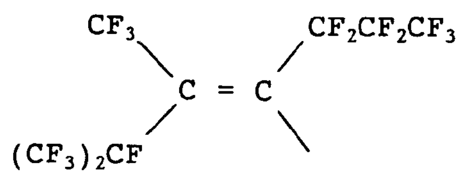

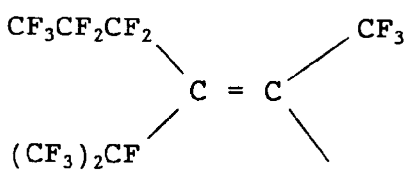

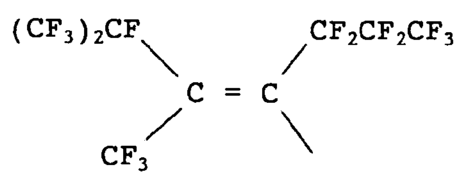

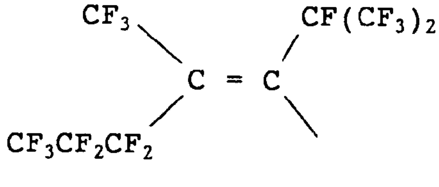

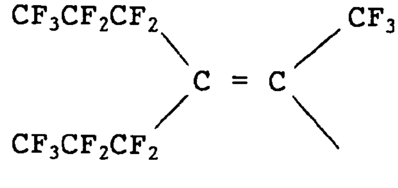

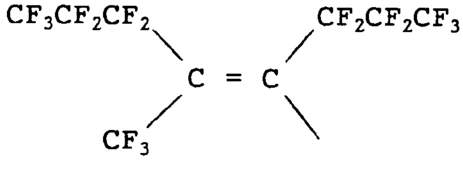

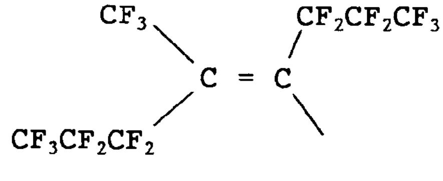

Also, A represents a single bond, a carbonyl group or

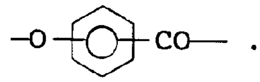

Further, B represents a structure formed by substituting the above group A for one of the hydrogen atoms of the hydroxyl groups of polyethylene glycol, polypropylene glycol, ethylene oxide addition polymer of polypropylene glycol and propylene glycol addition polymer of polyethylene glycol; one of the hydrogen atoms of the hydroxyl groups of a polyol such as glycerin, polyglycerin, pentaerythritol, sorbitan or the like; one of the hydrogen atoms of the hydroxyl groups of a polyethylene glycol adduct or polypropylene glycol adduct of one of the above polyols; one of the hydrogen atoms of the amino groups of a polyamine such as ethylenediamine, diethylenetriamine or the like; one of the hydrogen atoms of the hydroxyl and amino groups of a polyethylene glycol adduct or polypropylene glycol adduct of one of the above polyamines; one of the hydrogen atoms of the hydroxyl and amino groups of an ethanolamine such as monoethanolamine, diethanolamine, triethanolamine or the like; one of the hydrogen atoms of the hydroxyl and amino groups of a polyethylene glycol adduct or polypropylene glycol adduct of one of the above ethanolamines; or one of the hydrogen atoms of the hydroxyl groups of a bisphenol derivative represented by the following structural formula:

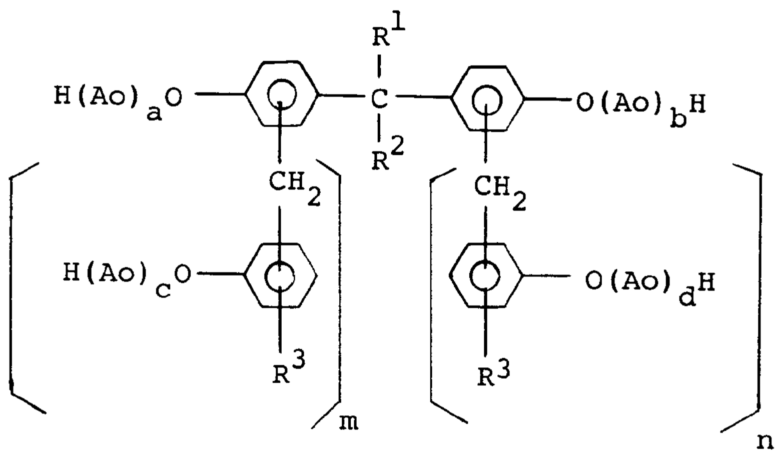

wherein plural Ao groups may be the same as or different from one another and each represents an oxyethylene group or an oxypropylene group; $R^1$ and $R^2$ may be the same as or different from each other and each represents a hydrogen atom, a methyl group or a $-CX_3$ group in which X's may be the same as or different from one another and each represents a halogen atom; plural $R^3$ groups may be the same as or different from one another and each represents a hydrogen atom, a halogen atom or an alkyl group having 1 to 4 carbon atoms; each of a, b, c and d represents an integer of 0 or more provided that a + b + c + d = 2-50; and each of m and n represents an integer of 0 to 2.

In the radiation-sensitive resist composition of this invention, the Surfactant A may be used alone or in admixture of two or more.

The amount of the Surfactant A used is preferably 0.001 to 1 part by weight, more preferably 0.002 to 0.5 part by weight, per 100 parts by weight of the main constituent composition described hereinafter. When the amount of the Surfactant A used is less than 0.001 part by weight, there is a fear that the striation-inhibiting effect may become insufficient and when it exceeds 1 part by weight, the developability of the resist composition tends to be reduced.

Main constituent composition

The composition constituting the radiation-sensitive resist composition and consisting of the main components other than the Surfactant A (said composition is referred to hereinafter as the main constituent composition) is described below.

The main constituent composition is a composition which can form a resist pattern having the desired shape by exposing it as such through the desired mask and then developing the same.

Typical examples of the main constituent composition include the following examples (a) to (d):

(a) A radiation-sensitive resin composition comprising (1) an alkali-soluble resin and (2) a compound having a quinonediazide group (referred to hereinafter as the quinonediazide compound) (said resin composition is referred to hereinafter as the main constituent composition A).

(b) A radiation-sensitive resin composition comprising (1) an alkali-soluble resin, (2) a radiation-sensitive acid-generating agent (referred to hereinafter as the acid generator) and (3) a compound having initially such properties that it inhibits the alkalisoluble resin from dissolving in an alkali (a dissolution inhibitor) and exhibiting, when it is decomposed in the presence of an acid, such properties that its effect of inhibiting the alkali-soluble resin from dissolving in an alkali is reduced or lost (a non-inhibitor) or the dissolution of the alkali-soluble resin in an alkali is accelerated (a dissolution accelerator) (said compound is referred to hereinafter as the dissolution-inhibiting agent) (said resin composition is referred to hereinafter as the main constituent composition B).

(c) A radiation-sensitive resin composition comprising (1) an alkali-insoluble or alkali-sparingly soluble resin having an acid-decomposable group such as a substituted methyl group, a 1-substituted ethyl group, a 1-branched alkyl group, a silyl group, a germyl group, an alkoxycarbonyl group, an acyl group, a cyclic group or the like which resin becomes an alkali-soluble resin when the acid-decomposable group decomposes owing to an acid (said resin is referred to hereinafter as the alkali-insoluble resin), and (2) the acid generator (said resin composition is referred to hereinafter as the main constituent composition C).

(d) A radiation-sensitive resin composition comprising (1) an alkali-soluble resin, (2) the acid generator and (3) a compound cross-linking the alkalisoluble resin in the presence of an acid (the compound is referred to hereinafter as the cross-linking agent) (said resin composition is referred to hereinafter as the main constituent composition D).

The quinonediazide compound used in the main constituent composition A includes, for example, 1,2-benzoquinonediazide-4-sulfonic acid esters, 1,2-naphthoquinonediazide-4-sulfonic acid esters, 1,2-naphthoquinonediazide-5-sulfonic acid esters and 1,2-naphthoquinonediazide-6-sulfonic acid esters of (poly)hydroxyphenyl alkyl ketones or (poly)hydroxyphenyl aryl ketones such as 2,3,4-trihydroxybenzophenone, 2,4,6-trihydroxybenzophenone, 2,3,4,4'-tetrahydroxybenzophenone, 2,2',3,4-tetrahydroxybenzophenone, 3'-methoxy-2,3,4,4'-tetrahydroxybenzophenone, 2,2',4,4'-tetrahydroxybenzophenone, 2,2',3,4,4'-pentahydroxybenzophenone, 2,2',3,4,6'-pentahydroxybenzophenone, 2,3,3',4,4',5'-hexahydroxybenzophenone, 2,3',4,4',5',6-hexahydroxybenzophenone and the like; 1,2-benzoquinonediazide-4-sulfonic acid esters, 1,2-naphthoquinonediazide-4-sulfonic acid esters, 1,2-naphthoquinonediazide-5-sulfonic acid esters and 1,2-naphthoquinonediazide-6-sulfonic acid esters of bis[(poly)hydroxyphenyl]-alkanes such as bis(4-hydroxyphenyl)methane, bis(2,4-dihydroxyphenyl)methane, bis(2,3,4-trihydroxyphenyl)methane, 2,2-bis(4-hydroxyphenyl)propane, 2,2-bis(2,4-dihydroxyphenyl)propane, 2,2-bis(2,3,4-trihydroxyphenyl)propane and the like; 1,2-benzoquinonediazide-4-sulfonic acid esters, 1,2-naphthoquinonediazide-4-sulfonic acid esters, 1,2-naphthoquinonediazide-5-sulfonic acid esters and 1,2-naphthoquinonediazide-6-sulfonic acid esters of (poly)hydroxytriphenylalkanes such as 4,4'-dihydroxytriphenylmethane, 4,4',4"-trihydroxytriphenylmethane, 2,2',5,5'-tetramethyl-2",4,4'-trihydroxytriphenylmethane, 3,3',5,5'-tetramethyl-2",4,4'-trihydroxytriphenylmethane, 4,4',5,5'-tetramethyl-2,2',2"-trihydroxytriphenylmethane, 2,2',5,5'-tetramethyl-4,4',4"-trihydroxytriphenylmethane, 1,1,1-tris(4-hydroxyphenyl)ethane, 1,1-bis(4-hydroxyphenyl)-1-phenylethane, 1,1-bis(4-hydroxyphenyl)-1-[4-{1-(4-hydroxyphenyl)-1-methylethyl}phenyl]ethane and the like; 1,2-benzoquinonediazide-4-sulfonic acid esters, 1,2-naphthoquinonediazide-4-sulfonic acid esters, 1,2- naphthoquinonediazide-5-sulfonic acid esters and 1,2-naphthoquinonediazide-6-sulfonic acid esters of polyhydroxyphenylflavans such as 2,4,4-trimethyl-2',4',7-trihydroxy-2-phenylflavan, 2,4,4'-trimethyl-2',4',5',6,7-pentahydroxy-2-phenylflavan and the like; etc.

These quinonediazide compounds may be used alone or in admixture of two or more.

The alkali-soluble resin used in the main constituent composition A include, for example, novolak resin, resol resin, polyvinylphenol or its derivative, styrene-maleic anhydride copolymer, polyvinyl hydroxybenzoate, free carboxyl group-containing (meth)acrylic acid resin and the like. In particular, novolak resin is preferable.

The novolak resin can be prepared by, for example, polycondensing a phenol with an aldehyde in the presence of an acid catalyst.

As the above phenol, preferable are, for example, o-cresol, m-cresol, p-cresol, 2,3-xylenol, 2,4-xylenol, 2,5-xylenol, 2,6-xylenol, 3,4-xylenol, 3,5-xylenol, 2,3,5-trimethylphenol, 3,4,5-trimethylphenol and the like.

These phenols may be used alone or in admixture of two or more.

Particularly preferable phenols are o-cresol, m-cresol, p-cresol, 2,5-xylenol, 3,5-xylenol and 2,3,5-trimethylphenol and combinations thereof.

Particularly preferable combinations of phenols are m-cresol/p-cresol=95-20/5-72 (mole ratio), m-cresol/3,5-xylenol/p-cresol=95-20/5-80/0-75 (mole ratio) and m-cresol/2,3,5-trimethylphenol/p-cresol=95-30/5-70/0-65 (mole ratio).

As the above-mentioned aldehyde, preferable are, for example, formaldehyde, acetaldehyde, propylaldehyde, benzaldehyde, phenylacetaldehyde, α-phenylpropylaldehyde, β-phenylpropylaldehyde, o-hydroxybenzaldehyde, m-hydroxybenzaldehyde, p-hydroxybenzaldehyde, o-chlorobenzaldehyde, m-chlorobenzaldehyde, p-chlorobenzaldehyde, o-nitrobenzaldehyde, m-nitrobenzaldehyde, p-nitrobenzaldehyde, o-methylbenzaldehyde, m-methylbenzaldehyde, p-methylbenzaldehyde, p-ethylbenzaldehyde, p-n-butylbenzaldehyde, furfural and the like, and particularly preferable is formaldehyde.

These aldehydes may be used alone or in admixture of two or more.

The formaldehyde-generating source when formaldehyde is used as the aldehyde is preferably, for example, formalin, trioxane, paraformaldehyde or a hemiformal such as methylhemiformal, ethylhemiformal, propylhemiformal, butylhemiformal, phenylhemiformal or the like, and particularly preferable are formalin and butylhemiformal.

These formaldehyde-generating sources may be used alone or in admixture of two or more.

The amount of the aldehyde used is preferably 0.7 to 3 moles, more preferably 0.8 to 1.5 moles, per mole of the phenol.

In the main constituent composition A, the alkali-soluble resins may be used alone or in admixture of two or more.

Also, the alkali-soluble resins used in the main constituent compositions B and D include resins having at least one of the recurring units represented by formula (2):

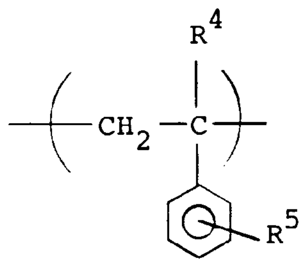

(2)

wherein $R^4$ represents a hydrogen atom or a methyl group and $R^5$ represents a hydroxyl group, a carboxyl group, a $-R^6COOH$ group, a $-OR^6COOH$ group or a $-OCOR^6COOH$ group in which $R^6$ represents a $-(CH_2)_e-$ group in which e represents an integer of 1 to 4, by formula (3):

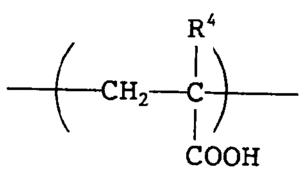

(3)

wherein $R^4$ is as defined in formula (2), by formula (4):

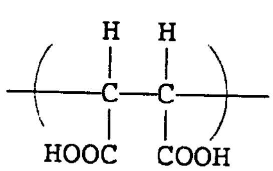

(4)

by formula (5):

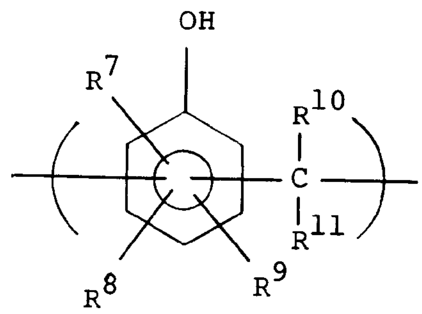

(5)

wherein $R^7$, $R^8$, $R^9$, $R^{10}$ and $R^{11}$ may be the same as or different from one another and each represents a hydrogen atom or an alkyl group having 1 to 4 carbon atoms.

The alkali-soluble resins used in the main constituent compositions B and D may be composed of only the recurring units represented by formulas (2) to (5) or may comprise other recurring units.

Such other recurring units include units formed by splitting the polymerizable double bonds of polymerizable double bond-containing monomers such as styrene, α-methylstyrene, vinyltoluene, (meth)acrylonitrile, fumaronitrile, (meth)acrylmaide, vinylpyridine, vinylpyrrolidone, vinylimidazole, vinylaniline, maleic anhydride and the like when the above alkali-soluble resins have recurring units represented by formulas (2) to (4).

When the above alkali-soluble resins have recurring units represented by formula (5), said other recurring unit may be those represented by formula (6):

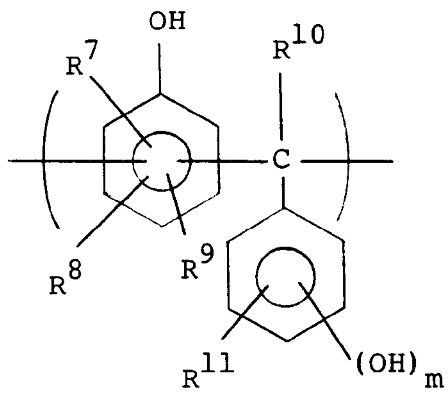

(6)

wherein $R^7$, $R^8$, $R^9$, $R^{10}$ and $R^{11}$ are as defined in formula (5) and these $R^7$ to $R^{11}$ groups may be the same as or different from those in formula (5), and m represents an integer of 0 to 2.

When the above alkali-soluble resins have said other recurring units, the content of the recurring units represented by formulas (2) to (5) is varied depending upon the kinds of said other recurring units and cannot be defined uniquely; however it is preferably at least 15 mole %, more preferably at least 20 mole %.

Among the above-mentioned alkali-soluble resins, the resins having the recurring unit represented by formula (2) and/or the recurring unit represented by formula (5) can be used in the form of a hydrogenation product. In this case, the hydrogenation degree is preferably 70% or less, more preferably 50% or less and most preferably 40% or less.

In the main constituent compositions B and D, the alkali-soluble resins may be used alone or in admixture of two or more.

The polystyrene-reduced weight average molecular weights of the alkali-soluble resins used in the main constituent compositions A, B and D (said weight average molecular weight is referred to hereinafter as Mw) is preferably in the range of 2,000 to 20,000. When the Mw's of these resins are less than 2,000, the film-formability tends to be lowered and when it exceeds 20,000 the coatability tends to be lowered.

The alkali-insoluble resin used in the main constituent composition C is an alkali-insoluble or alkali-sparingly soluble resin which is formed by substituting the above-mentioned acid-decomposable group for one of the hydrogen atoms of the acidic functional groups including phenolic hydroxyl group, carboxyl group and the like of an alkali-soluble resin such as the alkali-soluble resin mentioned as to the main constituent compositions B and D, and which is made alkalisoluble by decomposition of said acid-decomposable group. In this case, the acid-decomposable group means a group capable of decomposing in the presence of an acid, for example,

an acid generated upon exposure.

The term "alkali-insoluble" or "alkalisparingly soluble" used as to the alkali-insoluble resin refers to the properties that when under the developing conditions for forming a resist pattern on a resist film formed using the main constituent composition C, a coating film composed of only the alkali-insoluble resin is developed in place of said resist film, the alkaliinsoluble resin remains after the development in a film thickness of 50% or more of the initial film thickness.

Among the acid-decomposable groups of the alkali-insoluble resin, the substituted methyl group includes, for example, methoxymethyl group, methylthiomethyl group, ethoxymethyl group, ethylthiomethyl group, methoxyethoxymethyl group, benzyloxymethyl group, benzylthiomethyl group, phenacyl group, bromophenacyl group, methoxyphenacyl group, methylthiophenacyl group, α-methylphenacyl group, cyclopropylmethyl group, benzyl group, diphenylmethyl group, triphenylmethyl group, bromobenzyl group, nitrobenzyl group, methoxybenzyl group, methylthiobenzyl group, ethoxybenzyl group, ethylthiobenzyl group, piperonyl group, t-buthoxycarbonylmethyl group and the like.

The 1-substituted ethyl group includes, for example, 1-methoxyethyl group, 1-methylthioethyl group, 1,1-dimethoxyethyl group, 1-ethoxyethyl group, 1-ethylthioethyl group, 1,1-diethoxyethyl group, 1-phenoxyethyl group, 1-phenylthioethyl group, 1,1-diphenoxyethyl group, 1-benzyloxyethyl group, 1-benzylthioethyl group, 1-cyclopropylethyl group, 1-phenylethyl group, 1,1-diphenylethyl group and the like.

The 1-branched alkyl group includes, for example, isopropyl group, sec-butyl group, t-butyl group, 1,1-dimethylpropyl group, 1-methylbutyl group, 1,1-dimethylbutyl group and the like.

The silyl group includes, for example, trimethylsilyl group, ethyldimethylsilyl group, methyldiethylsilyl group, triethylsilyl group, isopropyldimethylsilyl group, methyldiisopropylsilyl group, triisopropylsilyl group, t-butyldimethylsilyl group, methyldi-t-butylsilyl group, tri-t-butylsilyl group, phenyldimethylsilyl group, methyldiphenylsilyl group, triphenylsilyl group and the like.

The germyl group includes, for example, trimethylgermyl group, ethyldimethylgermyl group, methyldiethylgermyl group, triethylgermyl group, isopropyldimethylgermyl group, methyldiisopropylgermyl group, triisopropylgermyl group, t-butyldimethylgermyl group, methyldi-t-butyl germyl group, tri-t-butylgermyl group, phenyldimethylgermyl group, methyldiphenylgermyl group, triphenylgermyl group and the like.

The alkoxycarbonyl group includes, for example, methoxycarbonyl group, ethoxycarbonyl group, isopropoxycarbonyl group, t-butoxycarbonyl group and the like.

The acyl group includes, for example, acetyl group, propionyl group, butyryl group, heptanoyl group, hexanoyl group, valeryl group, pivaloyl group, isovaleryl group, lauroyl group, myristoyl group, palmitoyl group, stearoyl group, oxalyl group, malonyl group, succinyl group, glutaryl group, adipoyl group, piperoyl group, suberoyl group, azelaoyl group, sebacoyl group, acryloyl group, propioloyl group, methacryloyl group, crotonoyl group, oleoyl group, maleoyl group, fumaroyl group, mesaconoyl group, camphoroyl group, benzoyl group, phthaloyl group, isophthaloyl group, terephthaloyl, naphthoyl, toluoyl, hydroatropoyl, atropoyl group, cynnamoyl group, furoyl group, thenoyl group, nicotinoyl group, isonicotinoyl group, p-toluenesulfonyl group, mesyl group and the like.

Furthermore, the cyclic group includes, for example, cyclopropyl group, cyclopentyl group, cyclohexyl group, cyclohexenyl group, 4-methoxycyclohexyl group, tetrahydropyranyl group, tetrahydrofuranyl group, tetrahydrothiopyranyl group, tetrahydrothiofuranyl group, 3-bromotetrahydropyranyl group, 4-methoxytetrahydropyranyl group, 4-methoxytetrahydrothiopyranyl group, 2-1,3-dioxoranyl group, 2-1,3-dithioxoranyl group, benzo-2-1,3-dioxoranyl group, benzo-2-1,3-dithioxoranyl group and the like.

Among these acid-decomposable groups, preferable are t-butyl group, benzyl group, t-butoxycarbonyl group, tetrahydropyranyl group, tetrahydrofuranyl group, tetrahydrothiopyranyl group and tetrahydrothiofuranyl group.

The proportion of the acid-decomposable group introduced into the alkali-insoluble resin (the proportion of the acid-decomposable group to the total of the acidic functional group and the acid-decomposable group in the alkali-insoluble resin) is preferably 15 to 100%, more preferably 30 to 100%.

The alkali-insoluble resin can be produced by introducing at least one acid-decomposable group into a previously prepared alkali-soluble resin, or by (co)polymerization of a monomer having at least one acid-decomposable group, or (co)polyaddition and/or (co)polycondensation of a polyaddition component and/or polycondensation component having at least one acid-decomposable group.

The Mw of the above alkali-insoluble resin is preferably in the range of 1,500 to 20,000. When the Mw is less than 1,500, the film-formability tends to be reduced, and when it exceeds 20,000 the coatability tends to be deteriorated.

In the main constituent composition C, the alkali-insoluble resins may be used alone or in admixture of two or more.

Incidentally, the alkali-insoluble resin is a resin having such properties that it inhibits the alkali-soluble resin

from dissolving in an alkali (a dissolution inhibitor) and exhibiting, when it is decomposed in the presence of an acid, for example, an acid generated from the acid generator upon exposure, such properties that its effect of inhibiting the alkali-soluble resin from dissolving in an alkali is reduced or lost (a non-inhibitor) or the dissolution of the alkali-soluble resin in an alkali is accelerated (a dissolution accelerator), and hence, the alkaliinsoluble resin falls within the category of the dissolution-inhibiting agent in the main constituent composition B.

The acid generator used in the main constituent compositions B, C and D is a compound which is decomposed with a radiation (said exposure) to generate an acid. Such acid generator includes, for example, onium salt, haloalkyl group-containing compound, quinonediazide compound, sulfone compound, sulfonic acid ester compound, nitrobenzyl compound and the like.

Specific examples of the acid generator include the following compounds:

Onium salt: Iodonium salt, sulfonium salt, phosphonium salt, diazonium salt, ammonium salt and the like.

Preferable onium salts are compounds represented by formula (7):

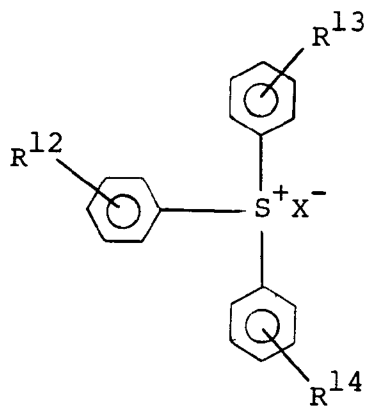

(7)

wherein $R^{12}$, $R^{13}$ and $R^{14}$ may be the same as or different from one another and each represents a hydrogen atom, a hydroxyl group, an amino group, a nitro group, a cyano group, an alkyl group having 1 to 4 carbon atoms or an alkoxy group having 1 to 4 carbon atoms and X represents $SbF_6$, $AsF_6$, $PF_6$, $BF_4$, $CF_3CO_2$, $ClO_4$, $CF_3SO_3$,

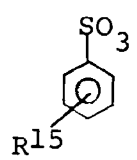

in which $R^{15}$ represents a hydrogen atom, an amino group, an anilino group, an alkyl group having 1 to 4 carbon atoms or an alkoxy group having 1 to 4 carbon atoms,

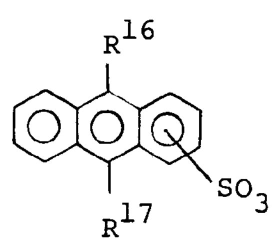

in which $R^{16}$ and $R^{17}$ may be the same as or different from each other and each represents an alkoxy group having 1 to 4 carbon atoms,

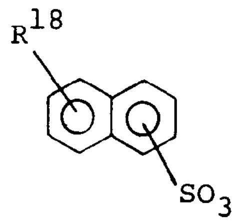

in which $R^{18}$ represents a hydrogen atom, an amino group, an anilino group, an alkyl group having 1 to 4 carbon atoms or an alkoxy group having 1 to 4 carbon atoms, or

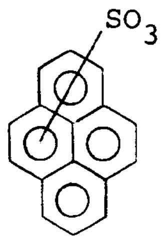

by formula (8):

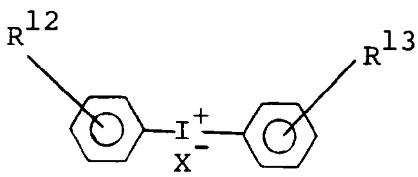

(8)

wherein $R^{12}$, $R^{13}$ and X are as defined in formula (7) and by formula (9):

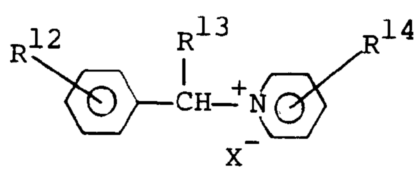

(9)

wherein $R^{12}$, $R^{13}$, $R^{14}$ and X are as defined in formula (7). Haloalkyl group-containing compound: Haloalkyl group-containing hydrocarbon compound, haloalkyl group-containing heterocyclic compound and the like.

Preferable haloalkyl group-containing compounds are compounds represented by formula (10):

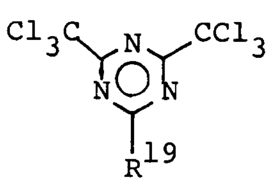

(10)

wherein $R^{19}$ represents a trichloromethyl group, a phenyl group, a methoxyphenyl group, a naphthyl group or a methoxynaphthyl group, and by formula (11):

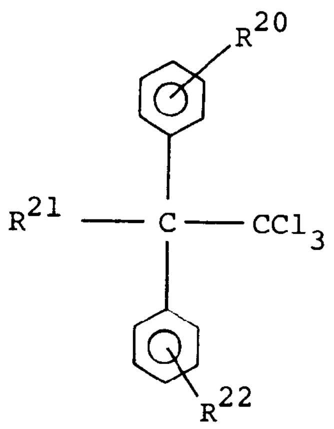

(11)

wherein $R^{20}$, $R^{21}$ and $R^{22}$ may be the same as or different from one another and each represents a hydrogen atom, a halogen atom, a methyl group, a methoxy group or a hydroxyl group.
Qinonediazide compound: Diazobenzoquinone compound, diazonaphthoquinone compound and the like.

Preferable quinonediazide compounds are compounds represented by formula (12):

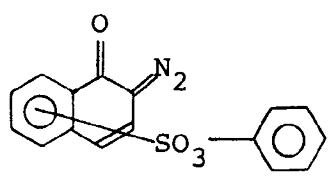

(12)

by formula (13):

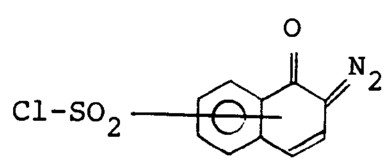

by formula (14):

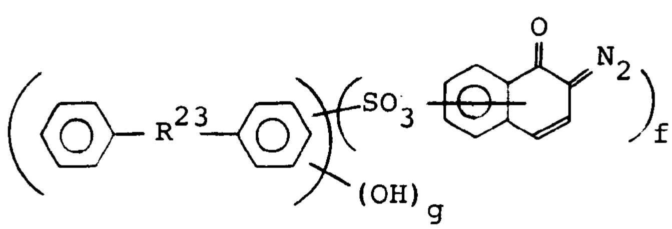

(14)

wherein $R^{23}$ represents a $-CH_2-$, $-C(CH_3)_2-$, -CO- or $-SO_2-$group, f represents an integer of 1 to 6, g represents an integer of 0 to 5 and f + g = 1-6, and by formula (15):

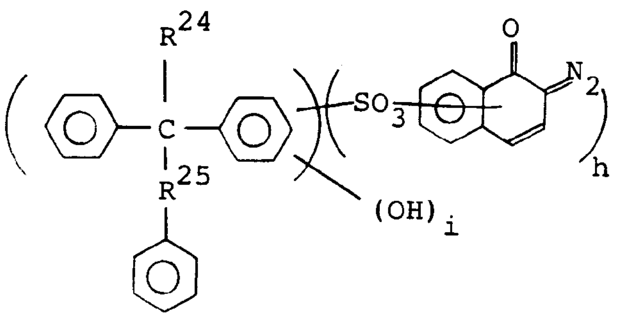

(15)

wherein $R^{24}$ represents a hydrogen atom or a methyl group, $R^{25}$ represents a $-CH_2-$, $-C(CH_3)_2-$, -CO- or $-SO_2-$ group, h represents an integer of 1 to 6, i represents an integer of 0 to 5 and h + i = 1-6.

Sulfone compound: β-Ketosulfone compound, β-sulfonylsulfone compound and the like.

Preferable sulfone compounds are compounds represented by formula (16):

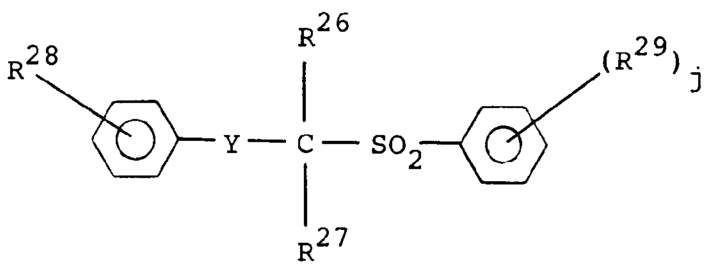

(16)

wherein Y represents a -CO- or $-SO_2-$ group, $R^{26}$, $R^{27}$, $R^{28}$ and $R^{29}$ may be the same as or different from one another and each represents a halogen atom or an alkyl group having 1 to 4 carbon atoms and j represents an integer of 0 to 3.

Sulfonic acid ester compound: Alkylsulfonic acid ester, haloalkylsulfonic acid ester, arylsulfonic acid ester, iminosulfonic acid ester and the like.

Preferable sulfonic acid ester compounds are compounds represented by formula (17):

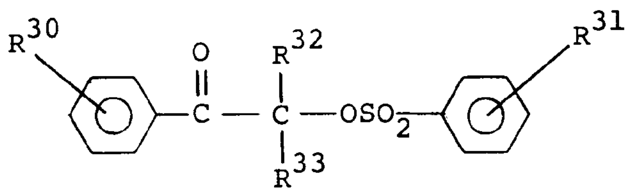

(17)

wherein $R^{30}$ and $R^{31}$ may be the same as or different from each other and each represents a hydrogen atom or an alkyl group having 1 to 4 carbon atoms, $R^{32}$ and $R^{33}$ may be the same as or different from each other and each represents a hydrogen atom, an alkyl group having 1 to 4 carbon atoms or an aryl group having 6 to 20 carbon atoms, by formula (18):

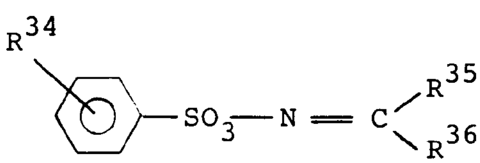

(18)

wherein $R^{34}$ represents a hydrogen atom or an alkyl group having 1 to 4 carbon atoms, $R^{35}$ and $R^{36}$ may be the same as or different from each other and each represents an alkyl group having 1 to 4 carbon atoms or an aryl group having 6 to 20 carbon atoms or $R^{35}$ and $R^{36}$ are bonded to each other to form a ring together with the carbon atom to which the two are attached, and by formula (19):

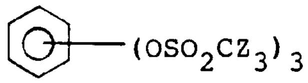

(19)

wherein Z represents a fluorine or chlorine atom. Nitrobenzyl compound: Nitrobenzylsulfonate compound, dinitrobenzylsulfonate compound and the like.

Preferable nitrobenzyl compounds are compounds represented by formula (20):

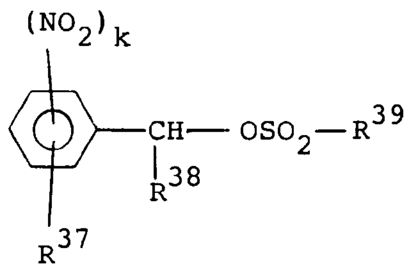

(20)

wherein $R^{37}$ represents an alkyl group having 1 to 4 carbon atoms, $R^{38}$ represents a hydrogen atom or a methyl group, and $R^{39}$ represents

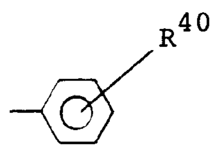

in which $R^{40}$ represents a hydrogen atom or a methyl group,

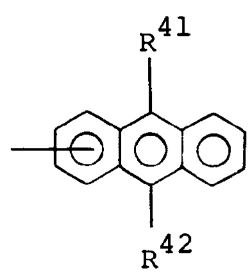

in which $R^{41}$ and $R^{42}$ may be the same as or different from each other and each represents an alkoxy group having 1 to 4 carbon atoms, or

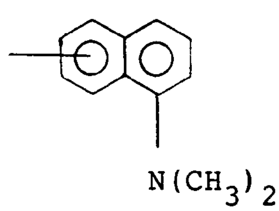

and k represents an integer of 1 to 3.

Among them, onium salts and quinonediazide compounds are particularly preferable acid generators.

The acid generators may be used alone or in admixture of two or more, and the amount thereof used is preferably 1 to 70 parts by weight, more preferably 3 to 50 parts by weight, and most preferably 3 to 20 parts by weight, per 100 parts by weight of the alkali-soluble resin and/or the alkali-insoluble resin. When the amount of the acid generator is less than 1 part by weight, the pattern-formability tends to be lowered and when it exceeds 70 parts by weight, there is a fear that scum may be formed.

The dissolution-inhibiting agent used in the main constituent composition B is a compound having such

properties that it inhibits the alkali-soluble resin from dissolving in an alkali (a dissolution inhibitor) and exhibiting, when it is decomposed in the presence of an acid, for example, an acid generated from the acid generator upon exposure, for example, hydrolyzed, such properties that its effect of inhibiting the alkalisoluble resin from dissolving in an alkali is reduced or lost (a non-inhibitor) or the dissolution of the alkalisoluble resin in an alkali is accelerated (a dissolution accelerator).

Such dissolution-inhibiting agent includes, for example, compounds formed by substituting at least one acid-decomposable substituent, which can decompose in the presence of an acid, for at least one hydrogen atom of the acidic functional group such as phenolic hydroxyl group, carboxyl group or the like of an acidic functional group-containing compounds.

Such acid-decomposable substituent includes such acid-decomposable groups as mentioned as to the alkali-insoluble resin in the main constituent composition C including substituted methyl groups, 1-substituted ethyl groups, 1-branched alkyl groups, silyl groups, germyl groups, alkoxycarbonyl groups, acyl groups, cyclic groups and the like.

The dissolution-inhibiting agent may be a low molecular weight compound or a high molecular weight compound, and specific examples of the low molecular weight compound include compounds represented by formula (21):

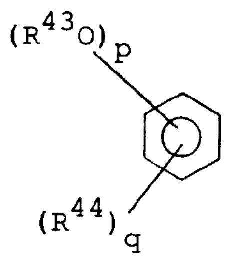

(21)

wherein $R^{43}$ represents a substituted methyl group, a 1-substituted ethyl group, a 1-branched alkyl group, a silyl group, a germyl group, an alkoxycarbonyl group, an acyl group or a cyclic group, and when plural $R^{43}$ groups are present, they may be the same as or different from one another; $R^{44}$ represents an alkyl group having 1 to 4 carbon atoms, a phenyl group or a naphthyl group, and when plural $R^{44}$ groups are present, they may be the same as or different from one another; p represents an integer of 1 or more; q represents an integer of 0 or more; and $p + q \leqq 6$, by formula (22):

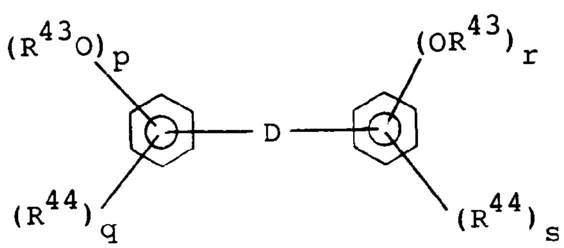

(22)

wherein $R^{43}$ and $R^{44}$ are as defined in formula (21), D rep-resents a single bond, -S-, -O-, -CO-, -COO-, -SO-, -$SO_2$-, -C($R^{45}$)($R^{46}$)- in which $R^{45}$ and $R^{46}$ may be the same as or different from each other and each represents a hydrogen atom, an alkyl group having 1 to 6 carbon atoms, an acyl group having 2 to 7 carbon atoms, a phenyl group or a naphthyl group, or

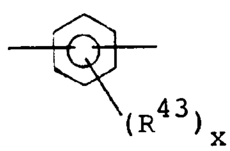

in which $R^{43}$ is as defined above and x represents an integer of 0 to 4; and p, q, r and s represent integers of 0 or more, provided that $p + q \leqq 5$, $r + s \leqq 5$, and $p + r \geqq 1$, by formula (23):

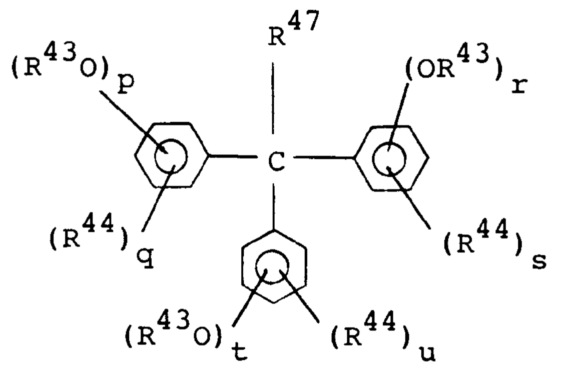

(23)

wherein $R^{43}$ and $R^{44}$ are as defined in formula (21); $R^{47}$ represents a hydrogen atom, an alkyl group having 1 to 4 carbon atoms or a phenyl group; and p, q, r, s, t and u are integers of 0 or more, provided that $p + q \leqq 5$, $r + s \leqq 5$, $t + u \leqq 5$, and $p + r + t \geqq 1$, by formula (24):

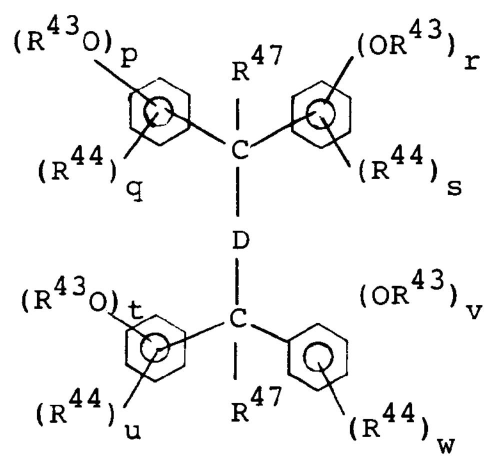

(24)

wherein $R^{43}$ and $R^{44}$ are as defined in formula (21); D is as defined in formula (22); $R^{47}$ is as defined in formula (23), and when plural $R^{47}$ groups are present, they may be the same as or different from one another; and p, q, r, s, t, u, v and w are integers of 0 or more, provided that $p + q \leqq 5$, $r + s \leqq 5$, $t + u \leqq 5$, $v + w \leqq 5$ and $p + r + t + v \geqq 1$, and by formula (25):

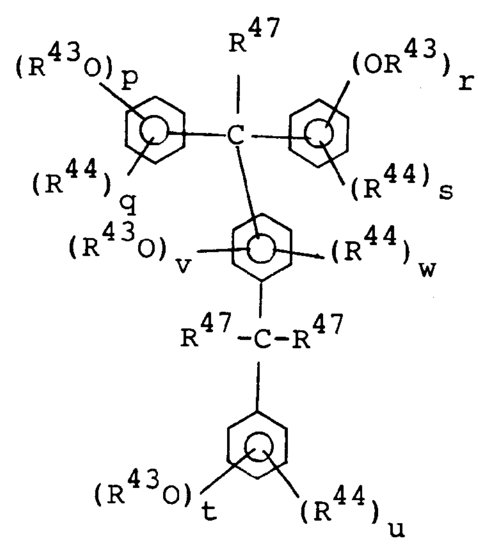

(25)

wherein $R^{43}$ and $R^{44}$ are as defined in formula (21); $R^{47}$ is as defined in formula (23), and when plural $R^{47}$ groups

are present, they may be the same as or different from one another; and p, q, r, s, t, u, v and w are integers of 0 or more, provided that $p + q \leqq 5$, $r + s \leqq 5$, $t + u \leqq 5$, $v + w \leqq 4$; and $p + r + t + v \geqq 1$.

The high molecular weight dissolution-inhibiting agent may be the alkali-insoluble resin defined as to the main constituent composition C.

In the main constituent composition B, the dissolution-inhibiting agents may be used alone or in admixture of two or more in both cases of the low molecular weight compound and the high molecular weight compound (namely, alkali-insoluble resin). It is also possible to use a combination of the low molecular weight compound with the high molecular weight compound.

The dissolution-inhibiting agent used is preferably 5 to 150 parts by weight, more preferably 5 to 100 parts by weight, per 100 parts by weight of the alkali-soluble resin.

Moreover, the cross-linking agent used in the main constituent composition D is a compound capable of cross-linking the alkali-soluble resin in the presence of an acid, for example, an acid generated upon exposure. Such cross-linking agent includes, for example, compounds having at least one cross-linking substituent having a cross-linking reactivity with the alkalisoluble resin, preferably aromatic compounds.

Such a cross-linking substituent includes, for example, groups represented by the formula:

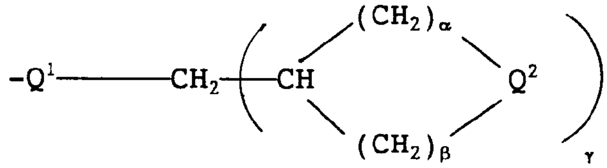

wherein $\gamma$ represents 1 or 2; $Q^1$ represents a single bond, -O-, -S-, -COO- or -NH- when $\gamma = 1$ or a trivalent nitrogen atom when $\gamma = 2$; $Q^2$ represents -O- or -S-; $\alpha$ represents an integer of 0 to 3; $\beta$ represents an integer of 1 to 3; and $\alpha + \beta = 1\text{-}4$, by the formula:

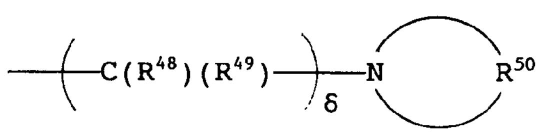

wherein $R^{48}$ and $R^{49}$ may be the same as or different from each other and each represents a hydrogen atom or an alkyl group having 1 to 4 carbon atoms; $R^{50}$ represents a divalent organic group having a hetero atom selected from the group consisting of an oxygen atom, a sulfur atom and a nitrogen atom and forming a 3 to 8-membered ring together with the nitrogen atom to which $R^{50}$ is attached; and $\delta$ represents an integer of 1 or more, by the formula:

$$-\left(C(R^{48})(R^{49})\right)_{\delta}-Q^3-R^{51}$$

wherein $Q^3$ represents -O-, -COO- or -CO-; $R^{48}$ and $R^{49}$ may be the same as or different from each other and each represents a hydrogen atom or an alkyl group having 1 to 4 carbon atoms; $R^{51}$ represents an alkyl group having 1 to 5 carbon atoms, an aryl group having 6 to 12 carbon atoms or an aralkyl group having 7 to 14 carbon atoms; and $\delta$ represents an integer of 1 or more, by the formula:

$$-\left(C(R^{48})(R^{49})\right)_{\delta}-N(R^{52})(R^{53})$$

wherein $R^{48}$ and $R^{49}$ may be the same as or different from each other and each represents a hydrogen atom or an alkyl group having 1 to 4 carbon atoms; $R^{52}$ and $R^{53}$ may be the same as or different from each other and each represents an alkylol group having 1 to 5 carbon atoms or an alkoxyalkyl group having 1 to 5 carbon atoms; and $\delta$ represents an integer of 1 or more, and by the formula:

$-C(R^{54})=C(R^{55})(R^{56})$

wherein $R^{54}$, $R^{55}$ and $R^{56}$ may be the same as or different from one another and each represents a hydrogen atom or an alkyl group having 1 to 4 carbon atoms.

Specific examples of the above cross-linking substituent include, for example, glycidyl ether group, glycidyl ester group, glycidylamino group, methoxymethyl group, ethoxymethyl group, benzyloxymethyl group, dimethylaminomethyl group, diethylaminomethyl group, dimethylolaminomethyl group, diethylolaminomethyl group, morpholinomethyl group, acetoxymethyl group, benzoyloxymethyl group, formyl group, acetyl group, vinyl group, isopropenyl group and the like.

The compound having the cross-linking substituent includes, for example, bisphenol A type epoxy compounds, bisphenol F type epoxy compounds, bisphenol S type epoxy compounds, novolak resin type epoxy compounds, resol resin type epoxy compounds, poly(hydroxystyrene) type epoxy compounds, methylol group-containing benzoguanamine compounds, methylol group-containing urea compounds, methylol group-containing melamine compounds, methylol group-containing phenol compounds, alkoxyalkyl group-containing benzoguanamine compounds, alkoxyalkyl group-containing urea compounds, alkoxyalkyl group-containing melamine compounds, alkoxyalkyl group-containing phenol compounds, carboxymethyl group-containing benzoguanamine compounds, carboxymethyl group-containing urea compounds, carboxymethyl group-containing melamine compounds, carboxymethyl group-containing phenol compounds and the like.

Among these cross-linking substituent-containing compounds, preferable are methylol group-containing phenol compounds, methoxymethyl group-containing melamine compounds, methoxymethyl group-containing phenol compounds and acetoxymethyl group-containing phenol compounds and more preferable are methoxymethyl group-containing melamine compounds. Specific examples of the methoxymethyl group-containing melamine compounds are CYMEL 300, CYMEL 301, CYMEL 303 and CYMEL 305 (these are trade names of Mitsui Cyanamid Co., Ltd.) and the like.

As the cross-linking agent, there may be appropriately used resins given properties as crosslinking agent by introducing the above-mentioned crosslinking substituent into the acidic functional group of the alkali-soluble resin. In this case, the proportion of the cross-linking functional group introduced is adjusted to preferably 1 to 60%, more preferably 10 to 50% and most preferably 15 to 40%, based on the total acidic functional groups contained in the alkali-soluble resin. When the proportion of the cross-lining functional group introduced is less than 1%, the yield of residual film thickness as a resist is lowered and the meandering and swelling of pattern tend to be caused. When it exceeds 60%, the developability as a resist tends to be lowered.

In the main constituent composition D, the cross-linking agents may be used alone or in admixture of two or more.

In the main constituent composition D, the amount of the cross-linking agent used is preferably 5 to 95 parts by weight, more preferably 15 to 85 parts by weight, and most preferably 20 to 75 parts by weight, per 100 parts by weight of the alkali-soluble resin. When the amount of the cross-linking agent used is less than 5 parts by weight, the yield of residual film thickness of resist is lowered and there is a fear that the meandering and swelling of pattern may be caused, and when it exceeds 95 parts by weight, the developability of resist tends to be lowered.

The radiation-sensitive resist composition of this invention comprises the above-mentioned Surfactant A and the main constituent composition (for example, the main constituent composition A, B, C or D or the like) as the main components, and if necessary, various additives such as other surface active agents, sensitizing agents, dyes, pigments, halation-preventing agents, storage stabilizers, defoaming agents, shape-improving agents and the like may further be compounded therewith.

The radiation-sensitive resist composition of this invention, when used, is dissolved in a solvent so that the solid concentration becomes, for example, 5 to 50% by weight, and thereafter, filtered through a filter having a pore diameter of about 0.2 mm to prepare a composition solution.

The solvent which may be used in the preparation of the above composition solution includes, for example, ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol dimethyl ether, diethylene glycol diethyl ether, diethylene glycol dipropyl ether, diethylene glycol dibutyl ether, methyl Cellosolve acetate, ethyl Cellosolve acetate, propylene glycol monomethyl ether acetate, propylene glycol monoethyl ether acetate, propylene glycol monopropyl ether acetate, toluene, xylene, methyl ethyl ketone, cyclohexanone, 2-heptanone, 3-heptanone, 4-heptanone, ethyl 2-hydroxypropionate, ethyl 2-hydroxy-2-methylpropionate, ethyl ethoxyacetate, ethyl hydroxyacetate, methyl 2-hydroxy-3-methylbutyrate, methyl 3-methoxypropionate, ethyl 3-methoxypropionate, methyl 3-ethoxypropionate, ethyl 3-ethoxypropionate, 3-methoxybutyl acetate, 3-methyl-3-methoxybutyl acetate, 3-methyl-3-methoxybutyl propionate, 3-methyl-3-methoxybutyl butyrate, methyl pyruvate, ethyl pyruvate, propyl pyruvate, methyl acetate, ethyl acetate, propyl acetate, butyl acetate, methyl acetoacetate, ethyl acetoacetate and the like.

These solvents may be used alone or in admixture of two or more.

To the above solvent, if necessary, there may be added at least one high boiling solvent such as N-methylformamide, N,N-dimethylformamide, N-methylformanilide, N-methylacetamide, N,N-dimethylacetamide, N-methylpyrrolidone, dimethylsulfoxide, benzyl ethyl ether, dihexyl ether, acetonylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, phenyl Cellosolve acetate and the like.

The radiation-sensitive resist composition of this invention, particularly when applied to a substrate (such as silicon wafer, aluminum-coated wafer or the like) by a spin-coating method, can noticeably inhibit or prevent striation from being caused and exhibit such a remarkable effect that a coating film having a uniform thickness can be stably formed. Incidentally, it is needless to say that the radiation-sensitive resist composition of this invention can also be applied by other coating methods such as a flow-coating method, a roll coating method and the like.

The radiation-sensitive resist composition of this invention, after applied to a substrate, is subjected to usual operations such as prebaking, exposure, development and the like and, if necessary, additional operations such as baking after exposure and the like, to form a resist pattern on the substrate.

Incidentally, the radiations used in this invention are appropriately selected from ultraviolet rays such as g line, i line and the like; deep ultraviolet rays such as KrF excimer laser, line spectrum of mercury lamp and the like; X rays such as synchrotron radiation and the like; charged particle beams such as electron beam and the like; etc. depending upon the kind of the main constituent composition. Also, exposure conditions such as exposure dose and the like are appropriately adjusted depending upon the compounding recipe of the main constituent composition, the kind of additives and the like.

As the developing solution, there are used alkaline aqueous solutions prepared by dissolving an alkaline compound such as sodium hydroxide, potassium hydroxide, sodium carbonate, sodium silicate, sodium metasilicate, ammonia water, ethylamine, n-propylamine, diethylamine, di-n-propylamine, triethylamine, methyldiethylamine, dimethylethanolamine, triethanolamine, tetramethylammonium hydroxide, tetraethylammonium hydroxide, choline, pyrole, piperidine, 1,8-diazabicyclo[5.4.0]-7-undecene, 1,5-diazabicyclo[4.3.0]-5-nonene or the like, so that the concentration becomes preferably 1 to 10% by weight, more preferably 2 to 5% by weight.

Incidentally, when a developing solution consisting of such an alkaline aqueous solution is used, the developed product is generally washed with water and then dried.

## DESCRIPTION OF PREFERRED EMBODIMENTS

Examples and Comparative Examples are shown bellow to further explain this invention in more detail; however, this invention is not limited to them.

In the Examples and Comparative Examples, the following main constituent compositions were used.

### Main constituent composition a

A solution prepared by dissolving, in 37.0 g of methyl 3-methoxypropionate, 10.0 g of a novolak resin obtained by polycondensing a mixed cresol of m-cresol/p-cresol=60/40 (mole ratio) together with formaldehyde (Mw=8,000) and 3.0 g of a condensate of 2,3,4,4'-tetrahydroxybenzophenone/1,2-naphthoquinonediazide-5-sulfonyl chloride=1/3 (mole ratio).

### Main constituent composition b

A solution prepared by dissolving, in 37.0 g of methyl 3-methoxypropionate, 12.6 g of a resin obtained by substituting a t-butoxycarbonyl group for 20% of the hydroxyl group of poly(hydroxystyrene) (Mw=20,000) and 0.4 g of triphenylsulfonium trifluoromethanesulfonate.

### Main constituent composition c

A solution prepared by dissolving, in 37.0 g of methyl 3-methoxypropionate, 9.0 g of poly(hydroxystyrene) (Mw=8,000), 3.6 g of hexamethoxymethylmelamine and 0.4 g of 2-phenyl-4,6-bis(trichloromethyl)-1,3,5-triazine.

Main constituent composition d

A solution prepared by dissolving, in 37.0 g of ethyl lactate (ethyl 2-hydroxypropionate), 8.0 g of poly(hydroxystyrene) (Mw=12,000), 2.5 g of bisphenol A whose hydroxyl group had been substituted by a trimethylsilyl group and 0.5 g of triphenylsulfonium trifluoromethanesulfonate.

Examples

In each Example, Surfactant A represented by one of the following formulas was compounded with the main constituent composition a, b, c or d in a proportion of 0.01 part by weight per 100 parts by weight of the solids to prepare composition solutions. Incidentally, each of Surfactant A1 to A4 was a mixture of compounds having n being in the range of 10 to 18:

Surfactant A1:

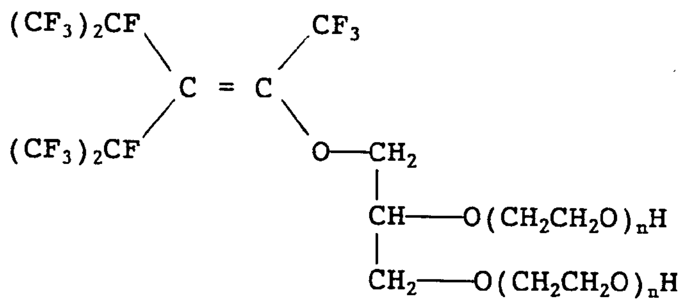

(n = 10 - 18)

Surfactant A2:

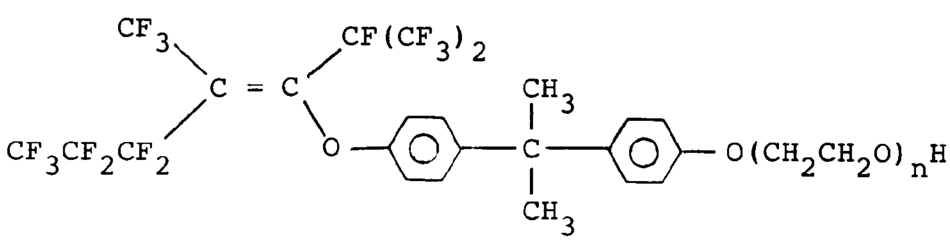

(n = 10 - 18)

Surfactant A3:

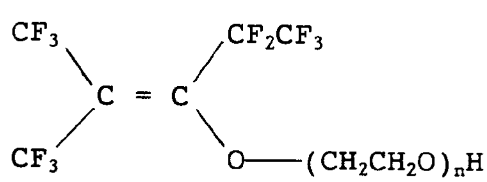

(n = 10 - 18)

Surfactant A4:

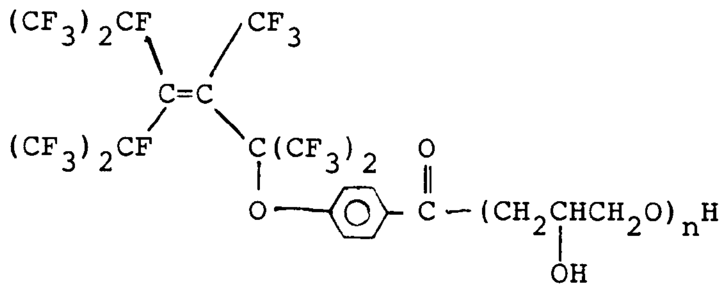

(n = 10 - 18)

Subsequently, 3 milliliters of each composition solution was put in a syringe, filtered through a fresh filter having a pore diameter of 0.5 μm while the filtrate was dropped on a silicon wafer having a diameter of 4 inches, to spin-coat the wafer at a revolution speed of 5,000 rpm, thereby forming a coating having a thickness of about 1 μm. Thereafter, the surface of the coating was observed by an optical microscope to check whether or not striation was caused. The results obtained are shown in Table 1.

From each coating, a resist pattern was formed under the conditions shown in Table 2 and then observed by a scanning type electron microscope to check the developability. The results obtained are shown in Table 3.

Comparative Examples

In each Comparative Example, a conventional surface active agent as shown in Table 1 was added to one of the main constituent compositions a to d in a proportion of 0.01 to 0.02 part by weight per 100 parts by weight of the solids to prepare composition solutions. In the same manner as in the Examples, each of the composition solutions obtained was filtered through a fresh filter to form a coating and whether or not striation was caused was checked. The results obtained are shown in Table 1.

Moreover, the conventional surface active agents were added to the main constituent compositions of the Comparative Examples as shown in Table 1 in the minimum necessary amounts in which striation was not caused when the composition solution was dropped on a silicon wafer in the same manner as in the Examples to spin-coat the wafer (the minimum amount: 0.10 to 0.15 part by weight per 100 parts by weight of the solids), to prepare composition solutions, and using the composition solutions, resist patterns were formed in the same manner as in the Examples. The resist patterns were observed by a scanning type electron microscope to check the developability. The results obtained are shown in Table 3.

Table 1

| | Surfactant | Amount added (part by weight*1) | Striation | | | |
|---|---|---|---|---|---|---|
| | | | Main constituent composition | | | |
| | | | a | b | c | d |
| Example | Surfactant A1 | 0.01 | No | No | No | No |
| | Surfactant A2 | 0.01 | No | No | No | No |
| | Surfactant A3 | 0.01 | No | No | No | No |
| | Surfactant A4 | 0.01 | No | No | No | No |
| Comp. Example | Megafac F-172*2 | 0.01 | Yes | Yes | Yes | Yes |
| | Unidyne DS-401*3 | 0.01 | Yes | Yes | Yes | Yes |
| | Fluorad FC-430*4 | 0.02 | Yes | Yes | Yes | Yes |

Note: *1: Per 100 parts by weight of the solids

*2: Trade name of DAINIPPON INK & CHEMICALS, INC. for a fluorine-containing surfactant

*3: Trade name of DAIKIN INDUSTRIE, LTD. for a fluorine-containing surfactant

*4: Trade name of 3M COMPANY for a fluorine-containing surfactant

Table 2

| | Main constituent composition | | | |
|---|---|---|---|---|
| | a | b | c | d |
| Film thickness | 1.16 μm | 1.00 μm | 1.00 μm | 1.00 μm |
| Prebaking | 90°C, 120 sec | 90°C, 120 sec | 90°C, 120 sec | 90°C, 120 sec |
| Exposure device | NSR150-G4D*5 | NSR2005-EX8A*6 | NSR2005-EX8A*6 | NSR2005-EX8A*6 |
| Baking after exposure | 110°C, 60 sec | 110°C, 60 sec | 90°C, 120 sec | 110°C, 60 sec |
| Development*7 | Paddle method, 25°C, 60 sec | Paddle method, 25°C, 60 sec | Paddle method, 25°C, 60 sec | Paddle method, 25°C, 60 sec |
| Washing | Flowing pure water, 20 sec | Flowing pure water, 20 sec | Flowing pure water, 20 sec | Flowing pure water, 20 sec |

Note: *5: g line exposure device manufactured by NIKON CORP.

*6: Excimer laser exposure device manufactured by NIKON CORP.

*7: Developing solution: 2.38 wt. % aqueous solution of tetramethylammonium hydroxide

Table 3

| | Surfactant | Amount added (part by wt.*1) | Developability | | | |
|---|---|---|---|---|---|---|
| | | | Main constituent composition | | | |
| | | | a | b | c | d |
| Example | Surfactant A1 | 0.01 | Good | Good | Good | Good |
| | Surfactant A2 | 0.01 | Good | Good | Good | Good |
| | Surfactant A3 | 0.01 | Good | Good | Good | Good |
| | Surfactant A4 | 0.01 | Good | Good | Good | Good |
| Comp. Example | Magafac F-172*2 | 0.10 | Bad | Bad | Bad | Bad |
| | Unidyne DS-401*3 | 0.10 | Bad | Bad | Bad | Bad |
| | Fluorad FC-430*4 | 0.15 | Bad | Bad | Bad | Bad |

Note: *1: Per 100 parts by weight of the solids

*2: Trade name of DAINIPPON INK & CHEMICALS, INC. for a fluorine-containing surfactant

*3: Trade name of DAIKIN INDUSTRIES, LTD. for a fluorine-containing surfactant

*4: Trade name of 3M COMPANY for a fluorine-containing surfactant

Bad: means that the undeveloped portion remained.

## Claims

1. A radiation-sensitive resist composition which comprises a radiation-sensitive resin composition and a surface active agent having a perfluoroalkenyl group having 6 or more carbon atoms in the molecule.

2. The radiation-sensitive resist composition according to Claim 1, wherein the perfluoroalkenyl group has 6, 9 or 12 carbon atoms.

3. The radiation-sensitive resist composition according to Claim 1, wherein the surface active agent is a compound represented by formula (I):

$$Rf - A - B$$

wherein Rf represents a perfluoroalkenyl group having 6 or more carbon atoms, A represents a single bond, a carbonyl group or

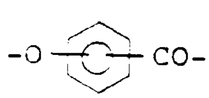

and B represents a structure formed by substituting the A group for one of the hydrogen atoms of the hydroxyl groups of polyethylene glycol, polypropylene glycol, ethylene oxide addition polymer of polypropylene glycol, propylene glycol addition polymer of polyethylene glycol, one of the hydrogen atoms of the hydroxyl groups of a polyol, one of the hydrogen atoms of the hydroxyl groups of polyethylene glycol adduct or polypropylene glycol adduct of a polyol, one of the hydrogen atoms of he amino groups of a polyamine, one of the hydrogen atoms or the hydroxyl and amino groups of polyethylene glycol adduct or polypropylene glycol adduct of a polyamine, one of the hydrogen atoms of the hydroxyl and amino groups of an ethanolamine, one of the hydrogen atoms of the hydroxyl and amino groups of a polyethylene glycol adduct or polypropylene glycol adduct of an ethanolamine or one of the hydrogen atoms of the hydroxyl groups of a bisphenol A derivative represented by the formula:

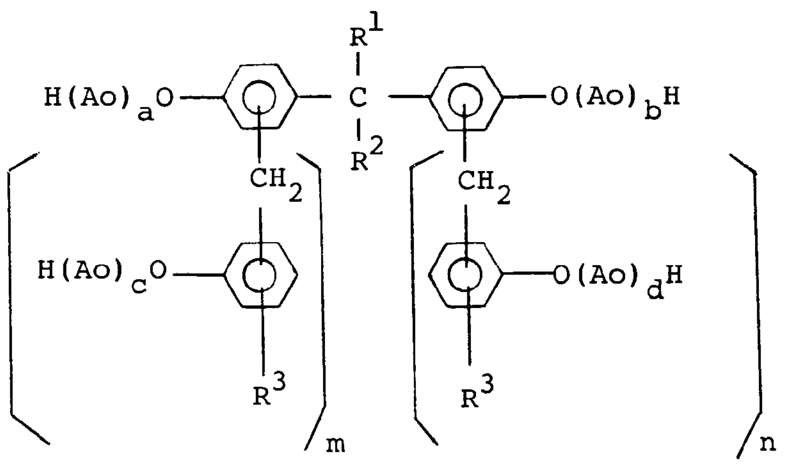

wherein Ao represents an oxyethylene group or an oxypropylene group and when plural Ao groups are present they may be the same as or different from one another, $R^1$ and $R^2$ may be the same as or different from each other and each represents a hydrogen atom, a methyl group or a $-CX_3$ in which X's may be the same as or different from one another and each represents a halogen atom, $R^3$ represents a hydrogen atom, a halogen atom or an alkyl group having 1 to 4 carbon atoms and when plural $R^3$ groups are present they may be the same as or different from one another, a, b, c and d represent integers of 0 or more, provided that a + b + c + d = 2-50, and m and n represent integers of 0 to 2.

4. The radiation-sensitive resist composition according to Claim 1, wherein the amount of the surface active agent contained is 0.001 to 1 part by weight per 100 parts by weight of the radiation-sensitive resin composition.

5. The radiation-sensitive resist composition according to Claim 1, wherein the amount of the surface active agent contained is 0.002 to 0.5 part by weight per 100 parts by weight of the radiation-sensitive resin composition.

6. The radiation-sensitive resist composition according to Claim 1, wherein the radiation-sensitive resin composition comprises (1) an alkali-soluble resin and (2) a compound having a quinonediazide group.

7. The radiation-sensitive resist composition according to Claim 1, wherein the radiation-sensitive resin composition comprises (1) an alkali-soluble resin, (2) a radiation-sensitive acid generating agent and (3) a compound having such properties that it inhibits the alkali-soluble resin from dissolving in an alkali and exhibiting, when it is decomposed in the presence of an acid, such properties that its effect of inhibiting the alkali-soluble resin from dissolving in an alkali is reduced or lost or the dissolution of the alkali-soluble resin in an alkali is accelerated.

8. The radiation-sensitive resist composition according to Claim 1, wherein the radiation-sensitive resin composition comprises (1) an alkali-insoluble or alkali-sparingly soluble resin having an acid-decomposable group which resin becomes an alkali-soluble resin when the acid-decomposable group decomposes owing to an acid and (2) a radiation-sensitive acid-generating agent.

9. The radiation-sensitive resist composition according to Claim 1, wherein the radiation-sensitive resin composition comprises (1) an alkali-soluble resin, (2) a radiation-sensitive acid-generating agent and (3) a compound cross-linking the alkali-soluble resin in the presence of an acid.

**10.** The radiation-sensitive resist composition according to Claim 6, wherein the alkali-soluble resin is selected from the group consisting of novolak resin, resol resin, polyvinylphenol resin, its derivative, styrene-maleic anhydride copolymer, polyvinyl hydroxybenzoate and free carboxyl group-containing (meth)acrylic acid resin.

**11.** The radiation-sensitive resist composition according to Claim 6, wherein the alkali-soluble resin is novolak resin.

**12.** The radiation-sensitive resist composition according to Claim 6, wherein the compound having a quinonediazide group is at least one member selected from the group consisting of 1,2-benzoquinonediazide-4-sulfonic acid esters, 1,2-naphthoquinonediazide-4-sulfonic acid esters, 1,2-naphthoquinonediazide-5-sulfonic acid esters and 1,2-naphthoquinonediazide-6-sulfonic acid esters of (poly)hydroxyphenyl alkyl ketones or (poly)hydroxyphenyl aryl ketones, bis[(poly)hydroxyphenyl)alkanes, (poly)hydroxytriphenylalkanes, and polyhydroxyphenylflavans.

**13.** The radiation-sensitive resist composition according to Claim 1, which is in the form of a solution in a solvent at a solids concentration of 5 to 50% by weight.

European Patent Office

# EUROPEAN SEARCH REPORT

Application Number
EP 94 30 4991

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DATABASE WPI Section Ch, Week 8901, Derwent Publications Ltd., London, GB; Class A85, AN 89-004145 & JP-A-63 282 919 (FUJI PHOTO FILM KK) 18 November 1988 * abstract * --- | 1-5,13 | G03F7/004 |
| A | EP-A-0 042 105 (HOECHST AG) ----- | | |
| | | | TECHNICAL FIELDS SEARCHED (Int.Cl.6) |
| | | | G03F |

The present search report has been drawn up for all claims

| Place of search | Date of completion of the search | Examiner |
|---|---|---|
| THE HAGUE | 19 October 1994 | Haenisch, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)